# EUROPÄISCHE PATENTSCHRIFT

(11) **EP 1 454 368 B1**
(45) Veröffentlichungstag und Bekanntmachung des Hinweises auf die Patenterteilung: **28.02.2007**
(21) Anmeldenummer: 02787417.1
(22) Anmeldetag: 04.12.2002
(51) Int. Cl.: H01L 33/00, B29C 45/14

(54) **VERFAHREN ZUM HERSTELLEN VON LEUCHTDIODEN**
METHOD FOR THE PRODUCTION OF LIGHT EMITTING DIODES
PROCEDE DE PRODUCTION DES DIODES ELECTROLUMINESCENTES

(30) Priorität: 05.12.2001 DE 10159522
(43) Veröffentlichungstag der Anmeldung: 08.09.2004
(73) Patentinhaber: G.L.I. Global Light Industries GmbH, 47475 Kamp-Lintfort (DE)
(72) Erfinder: RICKING, Thorsten, 47441 Moers (DE); OLKAY, Cem, 58454 Witten (DE); LEHMANN, Jörg, 46147 Oberhausen (DE); MANTH, Thomas, 52064 Aachen (DE)
(74) Vertreter: Schmid, Rudolf
(86) Internationale Anmeldenummer: PCT/DE2002/004440
(87) Internationale Veröffentlichungsnummer: WO 2003/054920

(56) Entgegenhaltungen:
- EP-A- 0 290 697
- DE-C- 19 604 492
- US-A- 5 964 030
- US-A- 5 998 243
- PATENT ABSTRACTS OF JAPAN vol. 017, no. 174 (E-1346), 5. April 1993 (1993-04-05) & JP 04 329680 A (SHARP CORP), 18. November 1992 (1992-11-18)
- PATENT ABSTRACTS OF JAPAN vol. 018, no. 577 (E-1625), 4. November 1994 (1994-11-04) -& JP 06 216412 A (STANLEY ELECTRIC CO), 5. August 1994 (1994-08-05)

## Beschreibung

Die vorliegende Anmeldung bezieht such auf ein Verfahren zum Herstellen von Leuchtdioden durch Spritzgießen in eine Form.

Aus der DE 196 04 492 ist ein Spritzgießwerkzeug zur Herstellung von Leuchtdioden (LED) bekannt. Bei der herzustellenden Leuchtdiode handelt es sich um eine Radial-LED mit einem zumindest bereichsweise zylindrischen Körper. Die Spritzgießdüse ist in der Form ca. in mittlerer Höhe des zylindrischen Abschnitt angeordnet und quer zur LED-Längsachse ausgerichtet. Dabei ist die Spritzgießdüse zumindest annähernd auf den Schwerpunkt des zu spritzgießenden Diodenkörpers ausgerichtet. Um die Spritzgießdüse herum befindet sich ein trichterförmiger Kanal zur Absaugung des aus der Form beim Spritzgießen verdrängten Gases. Trotz der interessanten Kombination aus der Anordnung der Spritzgießdüse und des Absaugkanals kann mit diesem Werkzeug nicht verhindert werden, dass die Ausschussquote - u.a. bedingt durch den Abriss des Bonddrahtes - sehr hoch ist.

Auch aus der JP 04 329680 A ist ebenfalls ein Spritzgießwerkzeug zur Herstellung von Leuchtdioden bekannt, das eine seitlich liegende Einspritzöffnung hat. Letztere liegt unterhalb der Chipebene.
Ferner ist aus der EP 0 290 697 A ein Spritzverfahren bekannt, bei dem mit Harztropfen geschützte Elektrodenenden in einer Form umspritzt werden. Hierzu wird über den Formboden der Spritzwerkstoff eingebracht und die Form über einen benachbarten Kanal evakuiert.

Der vorliegenden Erfindung liegt daher die Problemstellung zugrunde, ein Verfahren zum Herstellen von lichtleitenden Körpern zu entwickeln, bei dem bei üblichen Leistungen des Spritzgießvorganges die LED-Elektronik nicht beschädigt wird.

Diese Problemstellung wird mit den Merkmalen des Hauptanspruches gelöst. Dazu wird die Spritzgießform nach dem Einlegen der Elektronikteile und dem Verschließen über mindestens einen Saugkanal pro LED evakuiert. Hierbei hat dieser Saugkanal eine Evakuierungsöffnung, die im Bodenbereich der LED in der Nähe der Elektroden angeordnet ist. Der vor dem endgültigen Erstarren fließfähige Werkstoff wird zwischen dem Bodenbereich und dem LED-Chip bzw. der Reflektorwanne zumindest annähernd parallel zur Chipebene und zumindest annähernd normal zu einer von zwei Elektroden gebildeten Ebene über eine Spritzdüse eingespritzt. Dabei verläuft die Mittellinie des Einspritzstrahls zwischen zwei Elektroden. Der Saugkanal ist gegenüber der Elektrodenebene um mehrere Zehntelmillimeter - von der Spritzdüse weg - versetzt angeordnet.

Mit diesem Verfahren zur spritzgießtechnischen Herstellung wird durch eine bestimmte Vorgabe des Einspritzortes und der Einspritzrichtung in Verbindung mit einer an einem definierten Ort vorgenommenen Evakuierung der Spritzgießform eine Einströmbedingung geschaffen, die ein kontrolliertes Füllen der Form ohne jede Beschädigung der LED-Elektronik zulässt. Es ergibt sich hierbei eine Abdämpfung und Aufteilung des hochenergetischen Einspritzstrahls, so dass sich die Spritzgießform ausgehend vom LED-Bodenbereich bis zur LED-Spitze unter einem frühzeitigen Fixieren des Bonddrahtes - durch beidseitiges Umfließen - füllt.

Das Verfahren ist auch auf Leuchtdioden mit mehreren LED-Chips und Elektroden anwendbar.

Weitere Einzelheiten der Erfindung ergeben sich aus den Unteransprüchen und der nachfolgenden Beschreibung eines schematisch dargestellten Ausführungsbeispiels.
- Figur 1:: Seitenansicht einer gespritzten LED in der Form;
- Figur 2:: Vorderansicht zur LED aus Figur 1;
- Figur 3:: Draufsicht auf einen LED-Fertigungsverbund neben Spritzdüsen;
- Figur 4:: Unteransicht der LED aus Figur 1 mit Trennfugenverlauf.

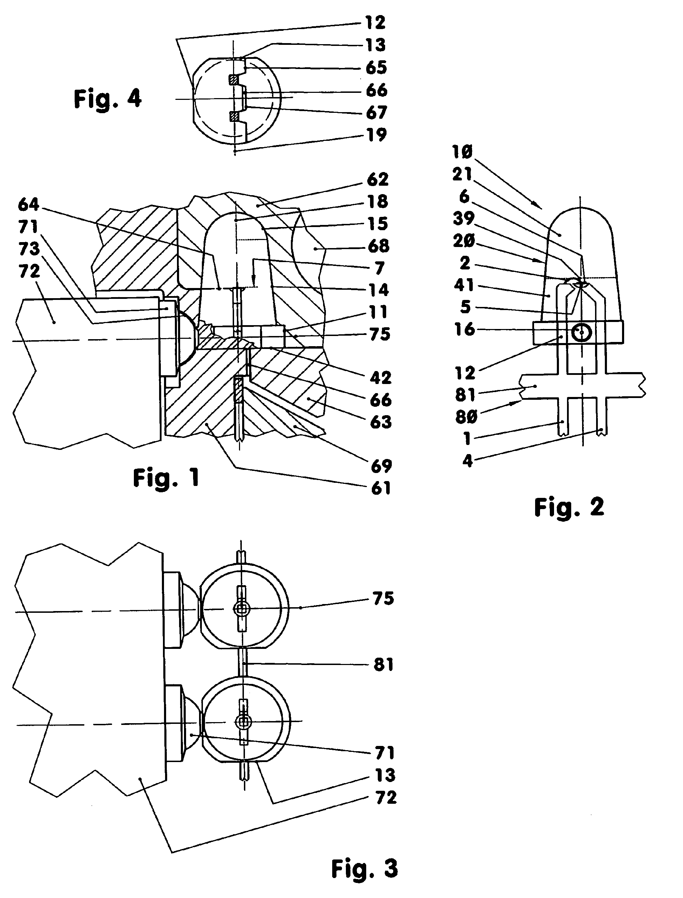

Die Figuren 1 bis 4 zeigen eine LED (10), deren lichtleitender Körper (20) spritzgusstechnisch in einem Spritzschritt hergestellt wird.

Die in den Figuren dargestellte LED (10) hat hierbei einen theoretisch in zwei Zonen (21, 41) aufgeteilten Körper (20), vgl. Figur 2. Die untere Zone (41) des Körpers (20) ist eine sog. Elektronikschutzzone, während die obere Zone (21) als Lichtleitzone bezeichnet wird. Beide Zonen sind durch eine fiktive Trennfuge (39) voneinander getrennt. Die Trennfuge (39) ist punktiert nur in Figur 2 dargestellt.

Die Elektronikschutzzone (41) umgibt in der Regel die in einer Ebene (19) liegenden elektrischen Anschlüsse (1, 4), den lichtemittierenden Chip (6), einen Bonddraht (2) und eine Reflektorwanne (5). Letztere ist z.B. Teil der Kathode (4). In der Reflektorwanne (5) sitzt der Chip (6). Der Chip (6) kontaktiert über den Bonddraht (2) die Anode (1). Die darüber liegende Lichtleitzone (21) transportiert das vom Chip (6) emittierte Licht möglichst verlustfrei zur Außenfläche der LED (10).

Der Werkstoff des Körpers (20) ist hier ein spritzfähiger transparenter, z.B. eingefärbter Thermoplast, z.B. ein modifiziertes Polymethylmethacrylimid (PMMI).

Der Körper (20) des Aus führungsbeispiels besteht bezüglich seiner räumlichen Gestaltung aus drei aneinandergesetzten Geometriekörpern (11, 14, 15). Der untere Geometriekörper (11) ist zumindest annähernd ein gerader Zylinder mit zwei zumindest annähernd parallelen Stirnflächen und z.B. zwei planen Abflachungen (12, 13). Die Abflachungen (12, 13) sind parallel zur LED-Längsachse (18) und schließen untereinander einen rechten Winkel ein. Eine Abflachung (12) ist parallel zur - durch die Mittellinien der Elektroden (1, 4) gebildeten - Elektrodenebene (19). Die untere Stirnfläche bildet den sog. Bodenbereich (42). An die obere Stirnfläche schließt sich ein gerader Kegelstumpf (14) an, der sich vom Zylinder (11) weg verjüngt. Auf dem Kegelstumpf (14) sitzt als dritter Geometriekörper eine Kalotte (15). Im LED-Längsschnitt befindet sich zwischen der Kalotte (15) und dem Kegelstumpf (14) beispielsweise ein tangentialer Übergang.

Der größere Stirnflächendurchmesser des Kegelstumpfes (14) misst im Ausführungsbeispiel ca. 5 mm. Er wird als Basisgröße bezeichnet. Die Verjüngung des Kegelstumpfes (14) beträgt z.B. 20% der Basisgröße. Die Gesamthöhe der LED (10) entspricht ca. 180% der Basisgröße. Die Höhe des Zylinders (11), der als flanschartiger Kragen bezüglich seines Radius über den Kegelstumpf um ca. 10% der-Basisgröße übersteht, bemisst ca. 30% der Basisgröße. Die Tiefe der Abflachungen (12, 13) beträgt ca. 8% der Basisgröße.

Der oberhalb des Chips (6) liegende Bereich des Kegelstumpfes (14) und die Kalotte (15) bilden die Hauptlichtaustrittsfläche.

Für die LED-Fertigung sind die Elektroden (1, 4) Teil eines i.d.R. gestanzten, sog. Elektrodenzauns (80). Innerhalb dieses Zauns sind die Elektroden (1, 4) durchgehend über Stege (81) miteinander verbunden. Ein Zaun (80) beinhaltet beispielsweise 32 Elektroden für 16 LEDs (10). Der minimale Abstand der nebeneinander im Zaun (80) integrierten LEDs (10) beträgt mindestens 10% des maximalen Durchmessers bzw. der maximalen Breite der einzelnen LED (10) in der Elektroden- bzw. Zaunebene (19). Im Ausführungsbeispiel beträgt der Abstand der Mittellinien (18) zweier benachbarter Lumineszenzdioden (10) ca. 150% der Basisgröße.

Für das Spritzgießen der LEDs (10) wird eine mehrteilige Form (61-63) verwendet, die zusammen mit der Spritzdüse (71) die Gestalt der Lumineszenzdiode (10) vorgibt. Der größte Teil der zu fertigenden Diode (10) wird von einer Schlittenform (62) umfasst. Letztere formt beispielsweise eine nahtlose Hauptlichtaustrittsfläche und den Teil der Umfangsflächen der Elektronikschutzzone (41), die einer benachbarten Basisform (61) abgewandt ist. Der Bodenbereich (42) und die restlichen Umfangsflächen der LED (10) werden mit Ausnahme eines Saugkanals (66) und der Spritzdüsenanlage durch die Basisform (61) und eine Hubform (63) verschlossen.

Die Basisform (61) ist z.B. eines der Grundelemente des Spritzgießwerkzeuges. Sie ist hier auf dem ortsfesten Teil des Werkzeuges befestigt und wird beim Entformen nicht bewegt. Sie weist eine Aussparung (73) auf, in die die Spritzdüse (71) abdichtend hineinragt.

Der Basisform (61) gegenüber ist die Hubform (63) angeordnet. Die Hubform (63) wird nach der Darstellung in Figur 1 zum Entformen nach rechts von der Basisform (61) wegbewegt. Bei geschlossener Form (61-63) berühren sich die Formteile (61) und (63) in einer in Figur 4 dargestellten Trennfuge (65). Die Trennfuge (65) teilt sich im Bereich zwischen den Elektroden (1, 4) zur Ausformung einer Öffnung (67). Die Öffnung (67) ist eine den Bodenbereich (42) berührende Kante des Saugkanals (66), vgl. Figur 1. Der Saugkanal (66) ist gegenüber der Elektrödenebene (19) um mehrere Zehntelmillimeter - von der Spritzdüse (71) weg - versetzt.

In der Hubform (63) ist ein Niederhalter (69) angeordnet. Der Niederhalter (69) ist verschiebbar - z.B. in Richtung des Öffnungshubs der Form - dort gelagert. Er klemmt den Elektrodenzaun (80) gegen die Basisform (61).

An der durch die Formteile (61, 63) gebildete Ebene, an der der spätere Bodenbereich (42) der LED (10) anliegt, und an die - die Spritzdüse (71) umgebende - Kontur der Basisform (61) schließt sich die Schlittenform (62) an. Zwischen der Schlittenform (62) und der Basisform (61) liegt eine räumlich abgestufte Trennfuge (64).

Die Schlittenform (62), die den größten Teil der künftigen LED-Oberfläche umgibt, ist durch mindestens einen Temperierkanal (68) durchzogen, um die Form und die sie umgebenden anderen Werkzeugteile z.B. mittels Wasserdampf bei beispielsweise 130°C zu temperieren. In der Figur 1 ist die Schlittenform (62) nur beispielhaft aus einem Teil dargestellt. Für den Fall, dass das diodenformgebende Teil innerhalb der Schlittenform (62) in einem separaten Schlittenträger sitzt, kann auch letzterer mit dem Temperierkanal ausgestattet sein.

Zur Vorbereitung des Spritzgießens ist die Form (61-63) geöffnet. Dazu sind die Formteile (63, 69), gemäß Figur 1, nach rechts abgehoben. Die Schlittenform (62) ist mittels einer nicht dargestellten Führung - unter einem Winkel von beispielsweise 25° gegenüber der Spritzdüsenmittellinie (75) - schräg nach rechts oben zur Seite gefahren. Der mit den Chips (6) und den entsprechenden Bonddrähten (2) ausgestattete Elektrodenzaun (80) wird eingelegt und über nicht dargestellte Indexstifte an der Basisform zentriert. Zum Schließen der Form (61-63) fährt die Hubform (63) auf die Basisform (61) zu. Der in ihr gelagerte Niederhalter (69) fährt solange in Schließrichtung weiter, bis der Elektrodenzaun (80) auf der Basisform (61) festgeklemmt ist. Beispielsweise zeitgleich bewegt sich die Schlittenform (62) auf die Formen (61) und (63) zu.

Über den Saugkanal (66) und z.B. über den Spalt zwischen der Hubform (63) und dem Niederhalter (69) wird der mit fließfähigem Werkstoff auszuspritzende Hohlraum der Form (61-63) evakuiert. Das Vakuum wird während des gesamten Spritzgießprozesses aufrechterhalten.

Unmittelbar nach dem Evakuieren wird der heiße, fließfähige Werkstoff über die jeweilige Spritzdüse (71), eine sog. Torpedodüse, in den entsprechenden Hohlraum der Form (61-63) eingespritzt. Die Mittellinie (75) der Spritzdüse (71) und des aus ihr austretenden Strahls ist hierbei normal zur Elektrodenebene (19) ausgerichtet. Sie liegt zwischen dem Bodenbereich (42) und dem untersten Punkt der Reflektorwanne (5). Im Ausführungsbeispiel befindet sich die Mittellinie (75) auf der halben Höhe des Zylinders (11). Dabei verläuft sie mittig zwischen den Elektroden (1, 4), vgl. Figur 3.

Während des Spritzgießvorganges schießt der flüssige Kunststoff mit einem Druck von 700 ± 300 bar in die evakuierte, temperierte Form (61-63) ein. Der Strahl passiert die Elektroden (1, 4) mittig und teilt sich an der der Spritzdüse (71) gegenüberliegenden Wandung der Form (62) auf. Hierbei verliert der Strahl soviel Energie, dass der einströmende Kunststoff beim Auffüllen des Hohlraumes, vgl. Figur 1, vor und hinter der Elektrodenebene (19) von unten nach oben fließt und dabei die empfindliche Elektronik, insbesondere den Bonddraht (2), nicht beschädigen bzw. abreißen kann.

Ggf. wird nach dem vollständigen Befüllen der Form der Werkstoffdruck aufrechterhalten um die Volumenschwindung in der Form auszugleichen. Dadurch ergibt sich eine gute Oberflächenqualität und eine hohe Abformgenauigkeit.

Nach dem Spritzgießen und dem Entformen werden in einem Vereinzelungsvorgang die Stege (81) zwischen den Lumineszenzdioden (10) und den Elektroden (1, 4) der einzelnen LEDs (10) z.B. durch Stanzen entfernt.

### Bezugszeichenliste:

- 1: Anschluss, Anode, Elektrode
- 2: Bonddraht, Aludraht

- 4: Anschluss, Kathode, Elektrode
- 5: Reflektorwanne
- 6: Chip
- 7: Chipebene

- 10: LED, Lumineszenzdiode, Diode
- 11: Zylinder, flanschartiger Kragen
- 12, 13: Abflachungen
- 14: Kegelstumpf
- 15: Kalotte
- 16: Abdruck der Spritzgießdüse

- 18: LED-Mittellinien, LED-Längsachsen
- 19: Elektrodenebene, Zaunebene

- 20: Körper
- 21: Lichtleitkörper

- 39: Trennfuge, fiktiv zwischen (21) und (41)

- 41: Elektronikschutzzone
- 42: Bodenbereich

- 61: Basisform
- 62: Schlittenform
- 63: Hubform
- 64: Trennfuge zwischen (61) und (62)
- 65: Trennfuge zwischen (61) und (63)
- 66: Saugkanal
- 67: Öffnung
- 68: Temperierkanal
- 69: Niederhalter

- 71: Spritzdüsen, Torpedodüsen, Heißkanaldüsen
- 72: Heizpatronen
- 73: Aussparung in (61)

- 75: Mittellinien der Spritzdüsen

- 80: Elektrodenzaun (Leadframe-Streifen)
- 81: Stege, obere

## Patentansprüche

1. Verfahren zum Herstellen von Leuchtdioden (LED) durch Spritzgießen in eine Form,
- wobei die einzelne LED (10) mindestens einen LED-Chip (6), mindestens zwei - mit dem LED-Chip (6) elektrisch verbundene - drahtförmige Elektroden (1, 4), und einen lichtleitenden Körper (20) aus einem vor dem endgültigen Erstarren Fliessfähigen Werkstoff umfasst,
- wobei der Hohlraum der Form (61-63) nach dem Einlegen der Elektronikteile (1-6) und dem Verschließen über mindestens einen Saugkanal (66) pro LED (10) evakuiert wird,
- wobei dieser Saugkanal (66) eine Öffnung (67) im Bodenbereich (42) der LED (10) hat, die im Bereich zwischen den Elektroden (1, 4) angeordnet ist,
- wobei der vor dem endgültigen Erstarren fließfähiger Werkstoff zwischen dem Bodenbereich (42) und dem LED-Chip (6) zumindest annähernd parallel zur Chipebene (7) und zumindest annähernd normal zu der von zwei Elektroden (1, 4) gebildeten Ebene (19) über eine Spritzdüse (71) eingespritzt wird, und
- wobei die Mittellinie (75) des Einspritzstrahls zwischen zwei Elektroden (1, 4) verläuft,
**dadurch gekennzeichnet, dass** der Saugkanal (66) gegenüber der Elektrodenebene (19) um mehrere Zehntelmillimeter - von der Spritzdüse (71) weg - versetzt angeordnet ist.

2. Herstellverfahren gemäß Anspruch 1, **dadurch gekennzeichnet, dass** das Vakuum im Hohlraum der Form (61-63) und den benachbarten Werkzeugbereichen während des gesamten Spritzgießvorganges aufrechterhalten wird.

3. Herstellverfahren gemäß Anspruch 1, **dadurch gekennzeichnet, dass** die Mittellinie (75) des Einspritzstrahls in der geometrischen Mitte zwischen zwei Elektroden (1, 4) verläuft.

4. Herstellverfahren gemäß Anspruch 1, **dadurch gekennzeichnet, dass** die Mittellinie (75) des Einspritzstrahls die Mittellinie (18) der LED (10) schneidet.

5. Herstellverfahren gemäß Anspruch 1, **dadurch gekennzeichnet, dass** bei einer LED (10) mit einem flanschartigen Kragen (11) die Mittellinie (75) des Einspritzstrahls auf halber Höhe des Kragens (11) verläuft.

## Claims

1. Manufacturing process for the production of light-emitting diodes (LED) through injection moulding into a mould,
wherein
- each said LED (10) is comprised of at least one LED chip (6), of at least two thread-like electrodes (1, 4) that are electrically connected to said LED chip (6) and of a light-guiding body (20) made of a material that is fluid before its final solidification,
- vacuum is created in the hollow space inside said mould (61-63) via at least one suction channel (66) per said LED (10)once the electronic components (1-6) have been placed inside and said mould closed,
- said suction channel (66) has a hole (67) in the bottom area (42) of said LED (10) that is located in the area between said electrodes (1, 4),
- an injection moulding nozzle (71) injects said material that is fluid before its final solidification between said bottom area (42) and said LED chip (6) in a way that is at least approximately parallel to the chip plane (7) and at least approximately perpendicular to the plane (19) built by two electrodes (1, 4)
- and the centre line (75) of said injection jet runs between said two electrodes (1, 4),
said suction channel (66) being located opposite the electrode plane (19) with a several millimetre shift away from said injection moulding nozzle (71).

2. The manufacturing process of claim 1, wherein said vacuum is maintained in the hollow space inside said mould (61-63) and in the neighbouring tool areas during the complete injection moulding process.

3. The manufacturing process of claim 1, wherein said centre line (75) of said injection nozzle jet runs along the geometrical centre between two electrodes (1, 4).

4. The manufacturing process of claim 1, wherein said centre line (75) of said injection jet cuts across the LED (10) centre line (18).

5. The manufacturing process of claim 1, wherein - when said LED (10) has a flange-type collar (11)- the centre line (75) of said injection jet runs at mid-height of collar (11).

## Revendications

1. Procédé de fabrication de diodes électroluminescentes (LED) par moulage par injection dans un moule,
- où chaque diode LED (10) comporte au moins une puce de LED (6), au moins deux électrodes filiformes (1, 4) reliées électriquement à ladite puce de LED (6) et un corps conducteur de la lumière (20) fait dans un matériau fluide avant sa solidification définitive,
- où, après le dépôt des composants électroniques (1-6) et la fermeture, le vide est créé dans l'espace creux du moule (61-63) par le biais d'au moins un canal d'aspiration (66) par diode LED (10),
- où ledit canal d'aspiration (66) comporte un orifice (67) à hauteur de la base (42) de la diode LED (10) qui est situé dans la zone entre lesdites électrodes (1, 4),
- où le matériau fluide avant sa solidification définitive est injecté par une buse d'injection (71) entre la base (42) et la puce de LED (6), au moins de manière approximativement parallèle au plan de la puce (7) et au moins à peu près perpendiculairement au plan (19) constitué par deux électrodes (1, 4)
- et où la ligne médiane (75) du jet d'injection se situe entre deux électrodes (1, 4),
**caractérisé en ce que**
ledit canal d'aspiration (66) est placé face au plan des électrodes (19), mais avec un décalage de plusieurs dixièmes de millimètres l'éloignant de la buse d'injection (71).

2. Procédé de fabrication selon la revendication 1, **caractérisé en ce que** le vide est maintenu dans l'espace creux du moule (61-63) et les zones d'outillage avoisinantes pendant toute la durée de l'opération d'injection par moulage.

3. Procédé de fabrication selon la revendication 1, **caractérisé en ce que** la ligne médiane(75) du jet d'injection s'inscrit dans le milieu géométrique entre deux électrodes (1, 4).

4. Procédé de fabrication selon la revendication 1, **caractérisé en ce que** la ligne médiane(75) du jet d'injection coupe la ligne médiane (18) de la diode LED (10).

5. Procédé de fabrication selon la revendication 1, **caractérisé en ce que**, dans le cas d'une diode (10) ayant un une collerette de type à bride (11), la ligne médiane(75) du jet d'injection se trouve à mi-hauteur de ladite collerette.
